# EUROPÄISCHE PATENTSCHRIFT

(11) **EP 1 678 007 B1**
(45) Veröffentlichungstag und Bekanntmachung des Hinweises auf die Patenterteilung: **07.07.2010**
(21) Anmeldenummer: 04741169.9
(22) Anmeldetag: 17.07.2004
(51) Int. Cl.: B60R 16/02, H05K 5/02

(54) **KRAFTFAHRZEUG-STEUERGER T**
MOTOR VEHICLE CONTROL DEVICE
APPAREIL DE COMMANDE POUR VEHICULE A MOTEUR

(30) Priorität: 30.10.2003 DE 10350714
(43) Veröffentlichungstag der Anmeldung: 12.07.2006
(73) Patentinhaber: Bayerische Motoren Werke Aktiengesellschaft, 80809 München (DE)
(72) Erfinder: BAUR, Richard, 85276 Pfaffenhofen (DE); RAUH, Helmut, 81543 München (DE); URBAHN, Jan, 80797 München (DE); WEIDNER, Marcus, 82362 Weilheim (DE); ACHATZ, Klaus, 82205 Gilching (DE)
(86) Internationale Anmeldenummer: PCT/EP2004/008094
(87) Internationale Veröffentlichungsnummer: WO 2005/047064

(56) Entgegenhaltungen:
- DE-A- 10 107 550
- US-B1- 6 441 510

## Beschreibung

Die Erfindung betrifft ein Kraftfahrzeug-Steuergerät gemäss dem Oberbegriff des Patentanspruchs 1.

Bisherige Kraftfahrzeug-Steuergeräte, beispielsweise für die Steuerung des Bremssystems oder von Einrichtungen für den Fahrgastschutz, werden abhängig vom jeweiligen Fahrzeugmodell aufgebaut. Um den verschiedenen Ausstattungsvarianten innerhalb einer Modellreihe gerecht zu werden, können für ein Modell sogar mehrere Steuergeräte vorgesehen sein. Diese mehreren Steuergeräte unterscheiden sich in ihrem Inhalt, d. h. der Anzahl von Sensoren und/oder dem Umfang der Steuereinrichtungen. Sie können während der Laufzeit eines Modells zeitlich nacheinander und/oder zeitgleich eingesetzt werden.

Für den Hersteller von Kraftfahrzeug-Steuergeräten und den Fahrzeughersteller, der diese Steuergeräte verbaut und/oder im Ersatzteilhandel vertreibt, bedeutet dies einen hohen Aufwand hinsichtlich Logistik, Lagerhaltung und Montage.

Aus der DE 101 07 550 A1 ist es bekannt den Aufbau von Kraftfahrzeug-Steuergeräten mit richtungsabhängigen Sensoren so zu wählen, dass mit geringem Aufwand Kraftfahrzeug-Steuergeräte hergestellt werden können, die sich für die unterschiedlichen Fahrzeugmodelle und Einbaulagen eigenen. Hierzu werden die richtungsabhängigen Sensoren in einem eigenen Sensorgehäuse angeordnet und das Sensorgehäuse in einem Einheitsgehäuse mit einer Ausrichtung eingebaut, die gemäss den jeweiligen Anforderungen unterschiedlich ist. Für eine Vielfalt von inhaltlich unterschiedlichen Steuergeräten ergibt sich daraus aber keine Reduktionsmöglichkeit.

Aus der DE 36 10 620 A1 ist ferner ein elektronischer Regler bekannt, der ein an unterschiedliche Anwendungen und/oder Auslegungen der von dem Regler gesteuerten Anlage, z. B. Bremsanlage, adaptierbares Universal-Programm gespeichert enthält ist und der über einen Adaptier-Schaltkreis verfügt, der bei der Herstellung des Reglers modifizierbar ist und der den Programmablauf der jeweiligen speziellen Anwendung und/oder Auslegung anpasst.

Schließlich ist aus der JP 2003254283 A eine elektrische Pumpe mit variabler Geschwindigkeit bekannt, die eine Grundauslegung mit der Möglichkeit der spezifischen Anpassung besitzt.

Die Aufgabe der Erfindung besteht darin, den Aufbau von Kraftfahrzeug-Steuergeräten so zu vereinfachen, dass mit geringem Aufwand inhaltlich unterschiedliche Kraftfahrzeug-Steuergeräte hergestellt werden können, die sich für die unterschiedlichen Fahrzeuge einer Modellreihe eignen.

Die Aufgabe der Erfindung wird dadurch gelöst, dass die Kraftfahrzeug-Steuergeräte aus einem ersten und einem zweiten Teilgerät bestehen, wovon im ersten Teilgerät die Sensoren und/oder zugehörigen Steuereinrichtungsumfänge enthalten sind, die für alle Fahrzeuge einer Modellreihe vorhanden und baugleich sind, und wovon im zweiten Teilgerät die Sensoren und/oder Steuereinrichtungsumfänge enthalten sind, die für das individuelle Fahrzeug zusätzlich erforderlich sind.

Bei der Erfindung ist das in der Regel in seinem Umfang an Sensoren und/oder Steuereinrichtung größere erste Teilgerät für alle Fahrzeuge der Modellreihe identisch. Dadurch ergibt sich ein Teilumfang des Steuergeräts mit hoher Funktionalität, und auf Grund der in der Regel gegebenen großen Stückzahl mit geringem Preis, großer Qualität und Zuverlässigkeit. Der durch das zweite Teilgerät gebildete zweite Teilumfang besitzt folgende wesentlichen Eigenschaften:
Er ist in der Regel kleiner als der des ersten Teilgeräts. Dadurch wird auch die Baugröße klein. Damit wird die Unterbringung des zweiten Teilgeräts an dem Ort möglich, der unter physikalisch / funktionellen Gesichtspunkten am geeignetsten ist. Durch die vorgenommene Aufteilung der Funktionalität besitzt das gesamte Steuergerät eine geringere Komplexität.

Es ergibt sich eine größere Beherrschbarkeit und ein geringeres Entwicklungsrisiko verbunden mit einer größeren Zuverlässigkeit des Gesamtsystems Steuergerät. Dies zeigt sich beispielsweise an den Schnittstellen, die für die beiden Teilgeräte einzeln verifizierbar und freigebbar sind.

Beim Umfang des zweiten Teilgeräts kann es sich im extremsten Fall um eine Nullmenge handeln. Dies gilt dann, wenn das individuelle Fahrzeug eine Minimalausstattung / -funktionalität besitzt, die bei allen anderen Fahrzeugen der Modellreihe ebenfalls vorhanden ist, und wenn darüber hinaus für dieses Fahrzeug keine zusätzliche Funktionalität erforderlich ist.

Das zweite Teilgerät für den zweiten Teilumfang kann individuell aufgebaut und "maßgeschneidert" für das jeweilige Fahrzeug sein, um den über die Minimalausstattung hinausgehenden zusätzlichen Funktionsumfang abzudecken.

Die zweiten Teilgeräte können auch in einer begrenzten Anzahl von Standardgeräten aufgebaut sein, die jeweils für sich oder aber teilweise gemeinsam mit dem ersten Teilgerät verbaut werden können. Jedes dieser Standardgeräte besitzt beispielsweise einen Umfang, der für das individuelle Fahrzeug, bei dem es eingesetzt wird, ausreichend ist. Dabei kann es sich um einen Funktionsumfang handeln, der wiederum "maßgeschneidert" ist und die jeweiligen gegenüber der Minimalausstattung bestehenden zusätzlichen Umfänge abdeckt, oder aber über den tatsächlichen zusätzlichen Funktionsumfang hinausgeht. Ein Beispiel möge dies verdeutlichen:

Alle Fahrzeuge einer Modellreihe besitzen die Funktionen 1, 2, 3 und 4. Einige Fahrzeuge besitzen darüber hinaus eine Funktion 5, andere Fahrzeuge eine Funktion 6 und schließlich gibt es Fahrzeuge mit den Funktionen 1-6. Dieser Situation kann durch ein erstes Teilgerät mit den Funktionen 1-4 Rechnung getragen werden. Für die Fahrzeuge mit den weiteren Funktionen 5 und/oder 6 können verschiedene Teilgeräte vorgesehen sein.

Es können drei Teilgeräte mit den Funktionen "5" oder "6" oder "5 und 6" eingesetzt werden und beim jeweiligen Fahrzeug bedarfsgerecht zwischen den drei Teilgeräten ausgewählt werden. Oder aber es ist nur ein einziges zweites Teilgerät mit den Funktionen "5 und 6" vorgesehen und in jedem Fall eingesetzt, in dem der Funktionsumfang über den Minimalumfang hinausgeht. Dort, wo nur eine der beiden weiteren Funktionen vorgesehen ist, ergibt sich ein durch das zweite Teilgerät vorgehaltener größerer Funktionsumfang als tatsächlich benötigt. Da für die Realisierung jeder Funktion entsprechende Hardware vorgesehen ist, ist der ggf. größere Funktionsumfang ohne Belang.

Eine vorteilhafte Weiterbildung der Erfindung ergibt sich aus dem Patentanspruch 2. Danach sind im ersten Teilgerät die Sensoren und/oder zugehörigen Steuereinrichtungsumfänge enthalten, die für die Fahrzeuge mehrerer Modellreihen vorhanden und baugleich sind. Dadurch ergibt sich bei neuen Modell- oder Baureihen diesbezüglich nur noch ein kleines Entwicklungsrisiko, weil das erste Teilgerät und damit die Baugruppe mit dem größeren Komplexitätsgrad betriebsbewährt ist.

Eine weitere Ausgestaltung der Erfindung ergibt sich aus den Patentansprüchen 3 und/oder 4. Die Ausgangssignale des ersten Teilgeräts sind dem zweiten Teilgerät zu Kontrollzwecken zugeführt und umgekehrt. Voraussetzung dafür ist in der Regel, dass dem kontrollierenden Teilgerät auch die Eingangssignale des zu kontrollierenden Teilgeräts zugeführt sind. Dies lässt sich ohne besonderen Verbindungsaufwand erreichen, wenn die beiden Teilgeräte in einem gemeinsamen Gehäuse untergebracht sind.

Zusammengefasst ergeben sich folgende Vorteile:

Durch die Möglichkeit, das Steuergerät zweigeteilt aufzubauen, lassen sich die jeweiligen Teilgeräte eher am physikalisch richtigen Ort platziere. Das durch die zunehmende Komlexität steigende Risiko im Bezug auf den Erfolg der Prozesskette Entwicklung Serienanlauf und Serieneinsatz lässt sich verringern, indem nur noch jeweils die Umfänge zu entwickeln und zur Serienreife zu bringen sind, die sich gegenüber anderen Modellen unterscheiden.

## Patentansprüche

1. Kraftfahrzeug-Steuergerät mit einer mehrere Sensoren enthaltenden Sensoreinrichtung und mit einer zugehörigen Steuereinrichtung **dadurch gekennzeichnet, dass** es aus einem ersten und einem zweiten Teilgerät besteht, wovon im ersten Teilgerät die Sensoren und/oder zugehörigen Steuereinrichtungsumfänge enthalten sind, die für alle Fahrzeuge einer Modellreihe vorhanden und baugleich sind, und wovon im zweiten Teilgerät die Sensoren und/oder Steuereinrichtungsumfänge enthalten sind, die für das individuelle Fahrzeug erforderlich sind.

2. Steuergerät nach Patentanspruch 1, **dadurch gekennzeichnet, dass** im ersten Teilgerät die Sensoren und/oder zugehörigen Steuereinrichtungsumfänge enthalten sind ,die für die Fahrzeuge mehrerer Modellreihen vorhanden und baugleich sind.

3. Steuergerät nach Patentanspruch 1 oder, **dadurch gekennzeichnet, dass** die Ausgangssignale des ersten Teilgeräts dem zweiten Teilgerät zu Kontrollzwecken zugeführt sind.

4. Steuergerät nach einem der Patentansprüche 1 bis 3, **dadurch gekennzeichnet, dass** die Ausgangssignale des zweiten Teilgeräts dem ersten Teilgerät zu Kontrollzwecken zugeführt sind.

5. Steuergerät nach einem der Patentansprüche 1 bis 4, **dadurch gekennzeichnet, dass** das erste und das zweite Teilgerät in einem gemeinsamen Gehäuse angeordnet sind.

## Claims

1. A motor vehicle control device with a sensor mechanism containing a plurality of sensors and with an associated control mechanism, **characterised in that** it comprises a first and second part device, wherein the sensors and/or associated control mechanism peripheries, which are present and structurally identical for all vehicles of a model series, are contained in the first part device, and wherein the sensors and/or control mechanism peripheries, which are required for the individual vehicle, are contained in the second part device.

2. A control device according to claim 1, **characterised in that** the sensors and/or associated control mechanism peripheries, which are present and structurally identical for the vehicles of a plurality of model series, are contained in the first part device.

3. A control device according to claim 1 or 2, **characterised in that** the output signals of the first part device are fed to the second part device for control purposes.

4. A control device according to any one of claims 1 to 3, **characterised in that** the output signals of the second part device are fed to the first part device for control purposes.

5. A control device according to any one of claims 1 to 4, **characterised in that** the first and the second part device are arranged in a common housing.

## Revendications

1. Appareil de commande de véhicule automobile comportant une installation de capteurs à plusieurs capteurs et une installation de commande correspondante,
**caractérisé en ce qu'**
il se compose d'une première et d'une seconde partie d'appareil,
la première partie d'appareil comportant les capteurs et/ou les installations de commande correspondantes, associées à tous les véhicules d'une série de modèles et identiques en construction, et
la seconde partie d'appareil, comporte les capteurs et/ou les installations de commande nécessaires à chaque véhicule individuel.

2. Appareil de commande selon la revendication 1,
**caractérisé en ce que**
le premier appareil partiel comporte les capteurs et/ou les installations de commande correspondantes, existant pour les véhicules de plusieurs séries de modèle et qui ont la même construction.

3. Appareil de commande selon la revendication 1,
**caractérisé en ce que**
les signaux de sortie de la première partie d'appareil, sont fournis à la seconde partie d'appareil à des fins de contrôle.

4. Appareil de commande selon l'une des revendications 1 à 3,
**caractérisé en ce que**
les signaux de sortie de la seconde partie d'appareil, sont fournis à la première partie d'appareil à des fins de contrôle.

5. Appareil de commande selon l'une des revendications 1 à 4,
**caractérisé en ce que**
la première partie d'appareil et la seconde partie d'appareil, sont logées dans un boîtier commun.
